# EUROPEAN PATENT SPECIFICATION

(11) **EP 0 339 315 B1**
(45) Date of publication and mention of the grant of the patent: **27.07.1994**
(21) Application number: 89105948.7
(22) Date of filing: 05.04.1989
(51) Int. Cl.: H01L 21/302, H01L 23/544

(54) **A method for fabricating semiconductor devices which are protected from pattern contamination**
Verfahren zur Herstellung von Halbleiterbauelementen, die gegen Musterverunreinigungen geschützt sind
Méthode de fabrication de dispositifs semi-conducteurs protégés contre la contamination due aux étapes de configuration

(30) Priority: 28.04.1988 JP 105737/88
(43) Date of publication of application: 02.11.1989
(73) Proprietor: FUJITSU LIMITED, Kawasaki-shi, Kanagawa 211 (JP); KYUSHU FUJITSU ELECTRONICS LIMITED, Kagoshima, 895-14 (JP)
(72) Inventor: Shiraiwa, Hidehiko, Gresham Oregon, 97030 (US); Shirai, Hisatsugu Miyamaedaira Aberia 2-501, Kawasaki-shi Kanagawa, 213 (JP); Takahashi, Nobuhiro, Nakahara-ku Kawasaki-shi Kanagawa, 211 (JP); Nomura, Shinichi, Higashimorokata-gun Miyazaki, 880-22 (JP)
(74) Representative: Seeger, Wolfgang, Dipl.-Phys.

(56) References cited:
- FR-A- 2 282 162
- PATENT ABSTRACTS OF JAPAN, vol. 6, no. 151 (E-124)[1029], 11th August 1982; & JP-A-57 73 933
- IBM TECHNICAL DISCLOSURE BULLETIN, vol. 28, no. 4, September 1985, page 1788, New York, US; "Improvement of "D" level auto-align target through redesign of B level mask"

## Description

The present invention relates to methods for fabricating semiconductor devices, more precisely, it relates to improved methods for forming chip patterns which prevents the devices from a contamination caused by residues of removed patterns which are etched off by a photolithographic process, and it relates to a semiconductor device with a reduced number of loose residues.

One important factor which has a large effect on the production yield of semiconductor devices is contamination. Most of the semiconductor devices are fabricated in a clean room or on a laminar flow bench which flows a filtered air to remove dusts floating in the air. As the integration rate in a semiconductor chip increased, the problem of dust rejection became severer, and all of the integrated circuit (IC) chips are now fabricated in a super clean room.

The contamination rejection is performed thoroughly and as completely as considerable in all as the production steps, equipments, materials, chemicals and water used for the production. But the production still often suffers from contamination, and the yield is effected by that. Such a trend is becoming severe, and can not be ignored in the production of large scale integration (LSI) circuits.

An object of the present invention, therefore, is to reduce the contamination in production process of semiconductor devices.

Another object of the present invention is to provide a method which further reduces the contamination during the production processes.

Still another object of the present invention is to further improve the production yield of semiconductor devices.

Precise investigation of various contaminations on semiconductor substrates showed that there are a considerable amount of contamination spots which are considered to be broken pieces of removed portion of patterns which are etched off by photolithographic process. The origins of these broken pieces are found to be at the periphery of device areas and mark patterns. The former defines the device area on the chip and the latter is used for various mask alignment or checking the chips. Around these patterns there are often found tiny residues of the removed parts of the pattern. These residues arc dispersed over the substrate by succeeding process and cause the contamination spots.

FR-A-2 282 162 teaches a method for fabricating semiconductors wherein the edges of some of the protruding structures are covered during a subsequent procedure step. However, this document neither discloses the fact that a considerable amount of contamination spots are broken pieces of removed portions of patterns which are etched off by photolitographic process, nor does it teach or suggest a possibility to cover all edges of protruding structures.

These objects are solved by the independent claims 1, 2 and 6.

Other objects and advantages of the present invention will become apparent from the detailed description of preferred embodiments to follow taken in conjunction with the appended claims and accompanying drawings.
Fig. 1 shows a general outlook of an exemplar semiconductor substrate for ICs, wherein:
Fig. 1(a) is a schematic over view; and
Fig. 1(b) shows a partially enlarged view of a part of the substrate of Fig. 1(a).
Fig. 2 shows schematically how the residues of the removed parts of the pattern are formed in a prior art photolithographic process, wherein:
Fig. 2(a) shows a state when a device pattern and a mark pattern are respectively formed by polysilicon on a device area and a scribing area;
Fig. 2(b) shows a step when the substrate is coated with a phosphosilicate glass (PSG) film, and a photoresist film over it is patterned;
Fig. 2(c) shows a state when the PSG film is patterned by etching, at the same time another mark pattern is formed on the scribing area, and shows how a residue of PSG appears at the periphery of the marking pattern;
Fig. 2(d) shows a state when an aluminum film is deposited over the substrate, and a photoresist pattern is formed for the aluminum wiring; and
Fig. 2(e) shows a state, when the aluminum film is etched off leaving a wiring pattern, and shows how aluminum residues remain around the periphery of the device areas.
Fig. 3 shows schematically, how the edge covers are formed by the present invention to prevent the dispersion of the residues of the etched off patterns, wherein:
Fig. 3(a) shows a state when a polysilicon device pattern and a mark pattern are respectively formed on a device area and a scribing area;
Fig. 3(b) shows a state when the substrate is covered with a PSG film, and a photoresist film over it is patterned;
Fig. 3(c) shows a state when the PSG film is patterned by etching, and another mark pattern of PSG is formed on the scribing area, illustrating how an edge cover is formed by the PSG film over the mark pattern;
Fig. 3(d) shows a state when the substrate is coated by an aluminum film, and a photoresist over it has been patterned for aluminum wirings; and
Fig. 3(e) shows a state when the aluminum film is etched off to form the wirings, and at the same time second edge covers are formed by the aluminum film at the edge of the device area and around the mark patterns.
Fig. 4 is another embodiment applying the present invention in which the PSG film can not cover the polysilicon layer due to some design or material limitations, wherein Figs. 4(b), 4(c), 4(d) and 4(e) respectively show the stages corresponding to the stages 3(b), 3(c), 3(d) and 3(e) of the previous embodiment.
Fig. 5 shows an example of another mark pattern which is not covered entirely by the edge cover, wherein:
Fig. 5(a) is a cross sectional view, and;
Fig. 5(b) is an over view of the mark pattern.

Throughout the drawings, same reference characters and numerals designate same or corresponding parts.

### DESCRIPTION OF PREFERRED EMBODIMENTS

As has been described before, the production yield of semiconductor devices largely depends on the contamination during the manufacturing process. Even though the production is carried out in a super clean room, and the used materials, water and chemicals are carefully checked for the absence of contamination, the substrate often suffers from contamination spots. The occurrence of trouble caused by contamination spots increases as the chip size of the IC becomes large, and the circuit design becomes fine, because only one spot of contamination on the chip causes the damage of the total circuit.

The inventors carefully investigated those contamination spots at various stages of production process, and noticed that a considerable part of the contamination spots are caused by tiny broken pieces of removed parts of the patterns. Further investigation showed that such broken pieces are often left around the periphery of device areas and around various mark patterns, when these patterns are formed by photolithographic etching process.

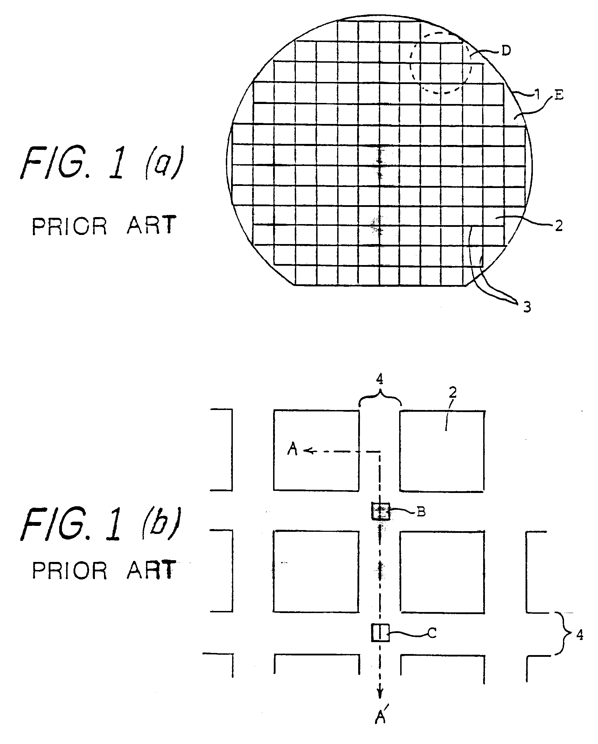

Fig. 1(a) shows a plan view of an exemplar substrate for ICs. It is sometimes called wafer from its outlook. On the substrate 1 are arranged in a grid form a plurality of device areas 2. In each of these device areas is formed the IC circuit (not shown), and when these device areas 2 are separated from each other by cutting the substrate 1 along cutting lines 3, IC chips are completed.

A portion of the substrate 1 encircled by a broken line D is shown enlarged in Fig. 1(b). There are scribing areas 4 running straight in both lateral and vertical directions, between the device areas 2. In Fig. 1(b), the scribing areas 4 are shown especially enlarged compared to the device area 2, for the purpose of explanation. The cutting line 3 (not shown) runs in these scribing areas.

In the scribing area 4 are shown small mark patterns B and C, which are used as a mark for various mask alignment or for various inspection instruments. These mark patterns may be formed in a marginal spaces E of the substrate 1. But since many marks are necessary for various manufacturing processes and checking process of the substrate, such mark patterns are usually formed in the scribing area 4. After the production and inspection processes are finished, these mark patterns are mostly lost by dividing the substrate along the cutting line 3.

Though the mark patterns are shown by squares in the figures, their shape may be circular, triangular, cross shape or any other, and their size also may be varied depending on the purpose and equipments using these mark patterns. Similarly, the shape, size and materials of any part of the device in the disclosures to follow, are given as an explanatory purpose and are not restrictive.

The residues of the etched off portion of the pattern are found around the periphery of the device area 2 or around the mark patterns B or C in Fig. 1(b). First, how these residues are formed will be explained briefly referring to an exemplary photolithographic etching process which is widely used for manufacturing semiconductor devices.

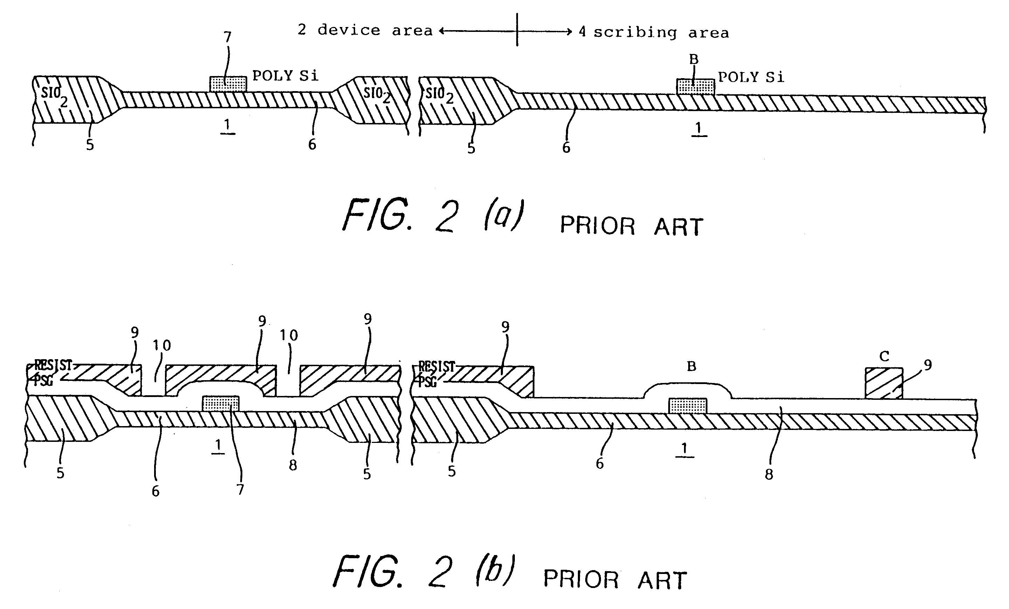

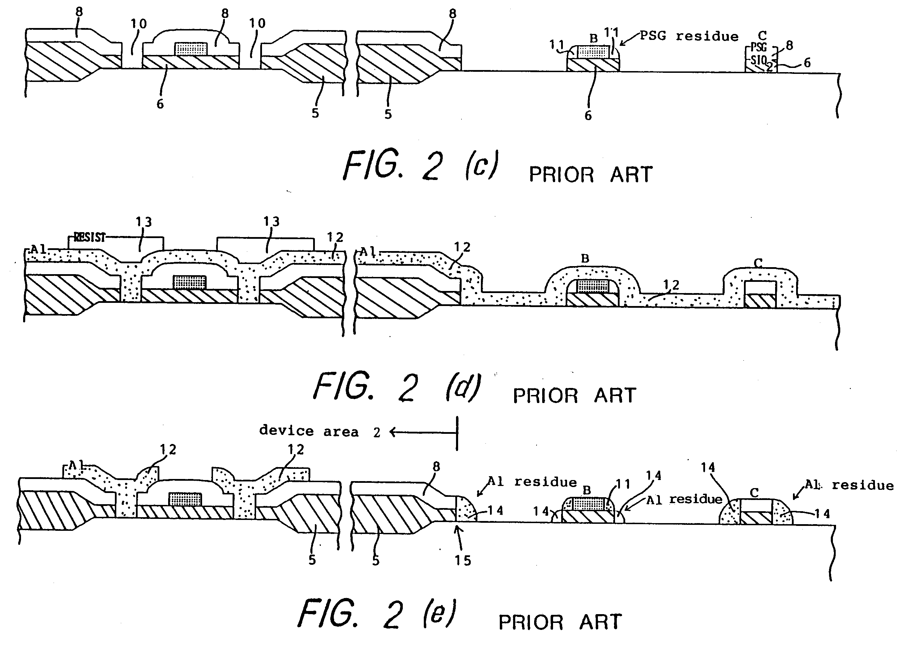

Fig. 2 shows a cross section of a semiconductor substrate cut along a broken chained line AA' in Fig. 1(a), showing some major steps for forming various patterns. The device area 2 is large, few mm² for example, compared to the scribing area which is about 100 µm in width. On the device area 2 is formed an IC circuit. In Fig. 2, only the edge portion of the device area 2 is shown.

Fig. 2(a) shows a state when the surface of the substate 1 is covered with silicon dioxide layers 5 and 6 having different thickness. The thicker silicon dioxide layer 5 may be a field oxide layer 5, and the thinner one 6 may be a gate oxide layer, for example, and respective thicknesses may be 0.5 µm and 50nm (500 A°) for example. An electrode 7, which might be a gate electrode for example, and a mark pattern B (called first mark pattern hereinafter) are respectively formed on the device area 2 and the scribing area 4. These oxide layers are formed by conventional semiconductor technology such as oxidation and photolithography. The electrode 7 and the first mark pattern B are made from polysilicon for example. These technology and materials are all conventional ones, therefore, further explanation will be omitted for the sake of simplicity.

Fig. 2(b) shows a state when the surface of the substate is coated with a phosphosilicate glass (PSG) layer 8 of about 1 µm thick for example, and coated with a photoresist film 9. The photoresist film 9 is patterned for contact holes 10, for example, and most part of the scribing area 4 is exposed leaving a portion for making a new mark pattern C (called second mark pattern hereinafter). In this step the first mark pattern B is used for aligning a photo mask for the contact holes 10. Thus, the contact holes 10 and the gate electrode 7, for example, are aligned in their positions to each other. Leaving these patterns, the photoresist film 9 is removed.

Fig. 2(c) shows a state when the PSG layer 8 and the silicon dioxide layer 6 which are exposed from the photoresist film 9 have been etched off to open the contact holes 10, and the photoresist film has been removed. At this stage, the second mark pattern C is formed by PSG. The etching method used in this stage may be of any kind such as chemical etching or dry etching including plasma reactive etching. It should be noticed that around the first mark pattern B is left a residue 11 of PSG. On the other hand, at the openings 10 or at the edge of the device area 2, the residue does not appear.

This is explained as follows, turning back to Fig. 2(b), the etching proceeds from the surface of the PSG layer 8 toward the thickness direction of the PSG layer. When the etching front reaches the bottom of the PSG layer 8, the silicon dioxide layer 6 and the top of the polysilicon mark pattern B appear . In order to avoid an overetching, the etching process is stopped at this point. And the etchant is switched to the chemical for etching the silicon dioxide layer 6. But as seen in the figure, the thickness of the PSG layer 8 is thick around the mark pattern B, so the residue 11 of the PSG is left. Such residues are more likely to be enhanced when an anisotropic etching process is applied than when an isotropic etching is used. Because the anisotropic etchant etches mainly in the vertical direction, while the isotropic etchant etches the layer both in the vertical and lateral directions.

Fig. 2(d) shows a state when an aluminum layer 12, about 1 µm thick for example, is formed over the substrate, and a photoresist film 13 over the aluminum layer 12 is patterned for a wiring. Fig. 2(e) shows a state after the photoresist film 13 has been removed leaving the wiring patterns. In this step, the alignment of the mask for the wiring pattern is done using the second mark pattern C for example.

Fig. 2(e) shows a state when the aluminum layer 12 is etched off leaving the wiring pattern, and the photoresist film 13 has been removed. Here again appear residues 14 of aluminum layer. It should be noticed that in this stage, the residues 14 of the aluminum layer appear not only around the mark patterns B and C, but also at the edge of the device area 2. The reason for the appearance of these residues are similar to those of the PSG residues described above. The vertical line 15 in Fig. 2(e) indicates the edge of the device area 2, that is the edge of chip pattern. Since the device area is much larger than the mark patterns, the chance of appearance of the residues is higher than that at around the mark patterns.

In the above description, the appearance of the residues was explained referring to patterning process of PSG and aluminum layers. But in practice, various kind of materials are used for various patterns, therefore, it will be apparent that various kinds or residues may appear in various etching process.

Such residues should be removed completely. But it is very difficult to etch them off perfectly. Further, the anisotropic characteristics of the etching enhances the occurrence of such residues. However, such residues are very tiny ones, less than 1 µm in size, and easily overlooked. If the etching is done too strong to remove these residues, overetching occurs. But recently the pattern of devices are becoming very fine, accordingly, the control of the etching is very critical, and overetching is undesirable. The unetched residues 11 and 14 are dropped off by various processes to follow, and they disperse all over the surface of the substrate and make contamination spots.

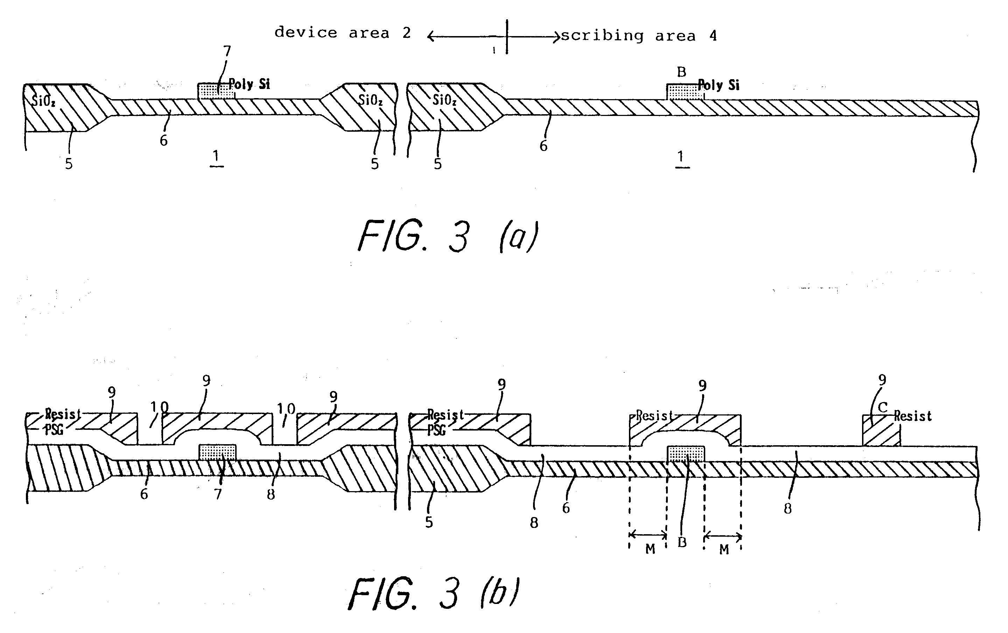

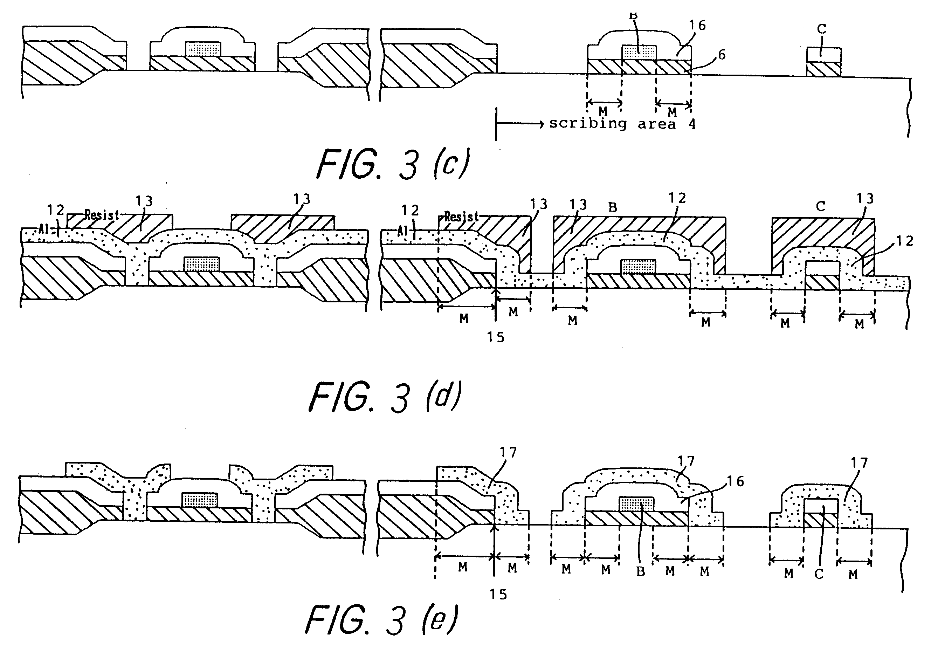

Now, how the bad effects caused by the residues of these removed patterns can be prevented by the present invention will be explained referring to an embodiment of Fig. 3, which corresponds to the case of Fig. 2. Fig. 3(a) shows a state when the gate electrode and a first mark pattern B are formed by polysilicon on the gate oxide layer 6. The gate electrode 7 and the gate oxide layer 6 imply a part of device formed at an edge portion of the device area 2. They may be of any other parts of the circuit formed in the device area 2. In this embodiment, the electrode 7 and the first mark pattern B are both made of polysilicon. But it will be obvious that they may be formed with any other material.

Fig. 3 (b) shows a state, when a PSG layer 8 is deposited over the substrate, and the photoresist film 9 coated over it is patterned to expose the portion of contact holes 10 and most part of the scribing area 4. Compared to Fig. 2(b), the photoresist film 9 is not removed completely from the scribing area 4. Apparently, the photoresist film 9 is left over the first mark pattern B. Of course the photoresist film 9 is also left at the position of the second mark pattern C. Further, it should be noticed that the photoresist film over the first mark pattern B is larger than the first mark pattern B, so the photoresist film is extended around the first mark pattern B by an amount of M, where M is a margin. The size of the margin M is not critical, it may be large unless it becomes too large to overlap with neighboring patterns. Therefore, the margin M may be practically from one to ten µm, for example.

When the PSG layer 8 and the silicon dioxide layer 6 are etched off, and the photoresist film 9 is removed, the structure becomes as shown in Fig. 3(c). Compared to Fig. 2(c), the PSG layer 8 is intentionally left over the first mark pattern B. There are no more residues, but there are edge covers 16. The edge cover 16 (called first edge cover hereinafter) extends outward on both sides of the first mark pattern B by a margin M. The contact area between the edge cover 16 and the gate oxide layer 6 is much larger than that of the residues of PSG 11 of Fig. 2. Therefore, the edge cover 16 is tightly adhered to the gate oxide layer 6, and to the first mark pattern B. They never be dropped off by the succeeding process, and never make any contamination spot.

Fig. 3(d) illustrates a state, when an aluminum layer 12 is formed over the substrate, and a photoresist film 13 is applied on it, and is patterned. Compared to Fig. 2(d), the photoresist film 13 is not completely removed from the scribing area 4, but there are left the margins M outside of the mark patterns B and C. It should be noted that at this stage, the photoresist 13 is also left on both sides of the edge 15 of the device area 2, with a margin space M. The size of these margins M need not necessarily be equal to each other. As has been described before, the size of these margins M may be large unless they overlap with neighboring patterns, and practically the margin M may be from one to ten µm, for example.

When the aluminum layer 12 is etched off by reactive ion etching (RIE) using boron chloride (BCl₃) as an etchant gas for example, and the photoresist is removed, the substrate becomes as shown in Fig. 3(e). Compared to Fig. 2(e), the aluminum film 12 is intentionally left over and around the mark patterns B, C and on both sides of the edge 15 of the device area with margins M. This intentionally left aluminum layer becomes a second edge cover 17. Of course, the size of the margins M are not necessarily equal to each other. The effect of these second edge covers 17 are similar to that of the fist edge cover 16. Therefore, no residues of the etched off pattern appears, and thus the contamination spots caused by the residues are perfectly prevented.

In the above disclosure, all edges of the device area and mark patterns are covered with respective edge covers. In the present embodiment, these edge covers are made from aluminum, or PSG, because they are made by etching respectively the aluminum layer or PSG layer. But it will be apparent for the one skilled in the art that the material of these edge covers depends on the material used in the manufacturing process of the semiconductor device. Therefore, the material of the edge cover may be metal or insulator. Further, if there are third and fourth mark patterns, their edges are covered with respective edge covers. It will be understood that, each time when a mark pattern is formed, the edges of the mark pattern and the device area are covered with a respective edge cover which is formed in a later step which comes after the pattern making, and the material for making the edge cover is one of the materials used in the later step.

In the above disclosure of the first embodiment of Fig. 3, the mark patterns B are formed with a first layer, polysilicon for example, and coated by a second layer, PSG layer 8 for example (see Fig. 3(c)). But occasionally there are cases that the mark pattern B, for example, can not covered with the second layer, PSG layer for example. Such a case often occurs from design requirement of the device, or choice of machine or material restriction. For example, in Fig. 3(b), if it is necessary to use a positive photoresist as a resist film 9, the resist over the mark pattern B can not remain. Because in the mask alignment step using the mark pattern B, the mark pattern B is exposed, and the resist over the mark pattern B is washed off in the development process. So, the edge cover can not be formed over the mark pattern B.

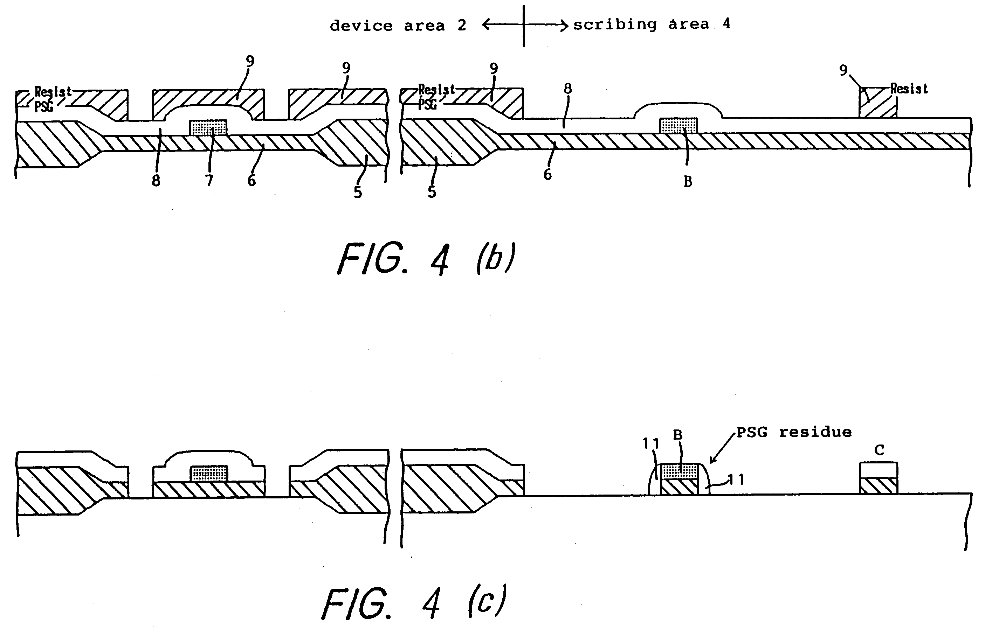

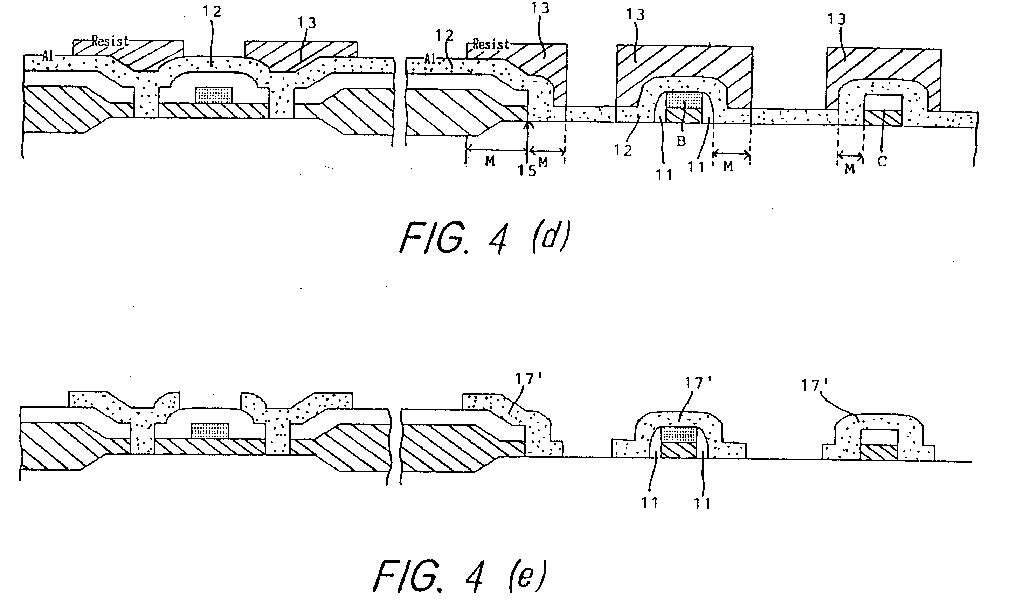

The second embodiment of the present invention is designed to overcome such problem. Figs. 4(b), 4(c), 4(d) and 4(e) show major steps of the second embodiment respectively corresponding to the steps of the first embodiment of Figs. 3(b) trough 3(e).

Fig. 4(b) illustrates a state corresponding to Fig. 3(b). The electrode 7 and the first mark pattern B are formed by a first layer of polysilicon formed over the silicon dioxide layer 6. The second layer, PSG layer 8 for example, is formed over the substrate covering the electrode 7 and the first mark pattern B, and a photoresist film 9 is applied on it and patterned. In this second embodiment, as shown in Fig. 4(b), the photoresist film 9 can not cover the first mark pattern B, though it forms the second mark pattern C, because the mark pattern B is exposed while the photo mask is aligned to the mark pattern B. Such a case may occur when a positive type mask is used, for example. So, the photoresist over the mark pattern B is washed off when it is developed.

So, as shown in Fig. 4(c), when the PSG layer 8 and the silicon dioxide layer 6 are etched off, the residues 11 may remain around the first mark pattern B. This is similar to the case of Fig. 2(c).

But in the next stage of Fig. 4(d), the mark pattern B and the residues 11 are completely covered by the aluminum layer 12. And the photoresist film 13 is patterned to form the edge cover over the mark patterns B, C and the edge 15 of the device area. Of course, proper margins M are left on both sides of them.

When the aluminum layer is etched off and the photoresist film is removed, the substrate becomes as shown in Fig. 4(e). As can be seen, the edge covers 17' are formed covering all edges of the patterns. Therefore, the contamination by the residues of the removed pattern is prevented.

As can be seen in the above second embodiment, the mark pattern B is made by the fist layer of polysilicon. Though the second layer of PSG has been washed off, the mark pattern B is covered by the third layer, aluminum layer for example. It will be apparent for the one skilled in the art that each of the mark pattern edge is covered by a respective edge cover which is made from a layer covering the mark pattern in one of proper steps which comes after the pattern making step, so, the edge cover is made from one of the materials used in the later step. In practical fabrication processes of ICs, there are many steps which form a layer over the substrate. Among of them there are preferable steps which use a desirable material for fabricating those edge covers. So, it is easy to choose proper steps for making these edge covers without adding any special step to form the edge cover.

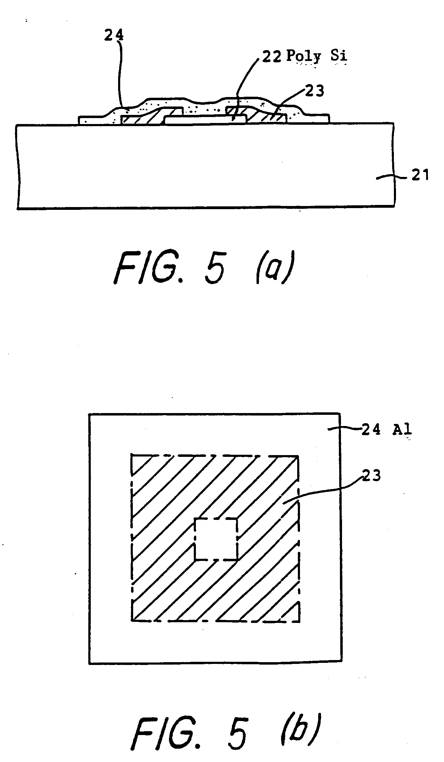

In all of the above embodiments, the mark patterns were considered to be covered completely by the edge cover. But it is not always necessary to cover the entire part of the mark pattern. Fig. 5 shows an example when the mark pattern is not covered entirely by the edge cover. Fig. 5(a) is a cross section, and Fig. 5(b) is an overview of such a mark pattern.

In Fig. 5, the mark pattern 22 is formed on a substrate 21, the mark pattern 22 is formed by polysilicon for example. In this example, the first edge cover 23 is made from silicon dioxide (SiO₂, because, the second layer which covers the pattern 22 was a SiO₂ layer. The edge cover 23 does not cover the mark pattern 22 entirely, and the mark pattern 22 is exposed at its center part from the edge cover 23. Further in this embodiment, the mark pattern is covered with aluminum layer 24, which is patterned to form a second edge cover. The process for fabricating such a pattern will be easily analogized by the one skilled in the art from the foregoing two embodiments. So, further description is omitted for the sake of simplicity.

Further it will be apparent, that the second edge cover covers the first edge cover which is formed before the second edge cover. Each edge cover is covered by succeeding edged covers which are formed in the later steps for covering other pattern edges.

Applying the production process of the present invention disclosed above, the contamination spots which often appeared in semiconductor production process have been avoided, and the yield of the IC production has been increased and stabilized.

## Claims

1. A method for fabricating semiconductor devices comprising a process for forming a plurality of device areas (2) which include semiconductor elements or circuits formed therein and a scribing area (4) for separating each of said device areas from each other, said device areas and said scribing area being formed on a semiconductor substrate (1, 6), said method comprising the steps of:
forming a plurality of mark patterns (B or C) in said scribing area (4) the mark patterns being formed from a layer covering also said device areas and forming there protruding edges;
forming a subsequent layer (8 or 12) over the substrate (6) covering said device areas (2) and scribing area (4) including said mark patterns (B or C), said subsequent layer (8 or 12) being a constituting layer for completion of said device areas; and
etching said subsequent layer (8 or 12) in such a way so as to form edge covers (16 or 17) on all the edges of the mark patterns (B) or (C) which protrude from the surface of the substrate (6 or 1) and on all those protruding edges of said device areas where residues are likely to be formed during the etching of said subsequent layer (8 or 12), which edge covers (16 or 17) contact the substrate (6 or 1) by extending outward from the edges by a margin (M) so as to ensure a tight adherence between each edge cover (16 or 17) and the substrate (6 or 1).

2. A method for fabricating semiconductor devices comprising a process for forming a plurality of device areas (2) which include semiconductor elements or circuits formed therein and a scribing area (4) for separating each of said device areas from each other, said device areas and said scribing area being formed on a semiconductor substrate (16), said method being characterized by the steps of:
forming a plurality of first mark patterns (B) in said scribing area (4), the first mark patterns (B) being formed from a layer covering also said device areas and forming there protruding edges;
forming a subsequent layer (8) over the substrate (6) covering said device areas (2) and scribing area (4) including said mark patterns (B), said subsequent layer (8) being a constituting layer for completion of said device areas; and
etching said subsequent layer (8) in such a way so as to form a plurality of second mark patterns (C) and leaving said first mark patterns (B) with residues (11) at the edge thereof;
forming a further layer (12) over the substrate (1, 6) covering said device areas (2) and scribing area (4) including said first and second mark patterns (B, C), said further layer (12) being a constituting layer for completion of said device areas; and
etching said further layer (12) in such a way so as to form edge covers (17') on all the edges of the mark patterns (B; C) which protrude from the surface of the substrate (1) and on all those protruding edges of said device areas where residues are likely to be formed during the etching of said further layer (12), which edge covers (17') contact the substrate (1) by extending outward from the edges by a margin (M) so as to ensure a tight adherence between each edge cover (17') and the substrate (1).

3. A method according to claim 1 or 2, wherein said steps are repeated in such a way that each edge cover is covered by succeeding edge covers which are formed in later steps for covering other pattern edges.

4. A method for fabricating semiconductor devices according to claims 1 or 2, wherein said margin (M) of extension of said edge covers (16, 17, 17') is approximately from one to ten µm.

5. A method for fabricating semiconductor devices according to claim 1 or 2, wherein said edge covers (16, 17 17') are patterned by an anisotropic etching process.

6. A semiconductor device having device areas (2) in which semiconductor elements or circuits are formed and scribing areas (4) dividing the device areas, wherein the device areas and the scribing areas are formed on a semiconductor substrate (1, 6), wherein further patterns with edges protruding from the surface of the substrate occur in the device areas and mark patterns (B, C) protruding from the substrate surface are formed in the scribing area, which mark patterns (B) may have residues (11) of etched-off layers adjacent their edges, and wherein all protruding edges occurring in the device areas and all edges of the mark patterns are covered by an edge cover 16, 17, 17'), which edge covers (16, 17, 17') contact the substrate (1, 6) by extending outward from the edges by a margin (M).

7. A semiconductor device according to claim 6, wherein said margin (M) of extension of said edge covers is in the range from one to ten µm.

## Patentansprüche

1. Ein Verfahren zum Herstellen von Halbleiteranordnungen mit einem Schritt zum Bilden einer Vielzahl von Anordnungsbereichen (2), die Halbleiterelemente oder -schaltungen enthalten, die darin gebildet sind, und eines Rißbereichs (4) zum Trennen jedes der genannten Anordnungsbereiche voneinander, wobei die genannten Anordnungsbereiche und der Rißbereich auf einem Halbleitersubstrat (1, 6) gebildet werden, welches Verfahren die Schritte umfaßt:
Bilden einer Vielzahl von Zeichenmustern (B oder C) in dem genannten Rißbereich (4), wobei die Zeichenmuster aus einer Schicht gebildet werden, die auch die genannten Anordnungsbereiche bedeckt und da hervorstehende Kanten bildet;
Bilden einer nachfolgenden Schicht (8 oder 12) über dem Substrat (6), die die genannten Anordnungsbereiche (2) und den Rißbereich (4) mit den genannten Zeichenmustern (B oder C) bedeckt, welche nachfolgende Schicht (8 oder 12) eine Bildungsschicht zum Fertigstellen der genannten Anordnungsbereiche ist; und
Ätzen der genannten nachfolgenden Schicht (8 oder 12) auf solch eine Weise, um Kantenabdeckungen (16 oder 17) auf allen Kanten der Zeichenmuster (B oder C), die von der Oberfläche des Substrats (6 oder 1) hervorstehen, und auf all jenen hervorstehenden Kanten der genannten Anordnungsbereiche zu bilden, an denen sich während des Ätzens der genannten nachfolgenden Schicht (8 oder 12) wahrscheinlich Rückstände bilden, welche Kantenabdeckungen (16 oder 17) das Substrat (6 oder 1) kontaktieren, indem sie sich von den Kanten um einen Rand (M) nach außen erstrecken, um ein festes Haften zwischen jeder Kantenabdeckung (16 oder 17) und dem Substrat (6 oder 1) zu gewährleisten.

2. Ein Verfahren zum Herstellen von Halbleiteranordnungen mit einen Prozeß zum Bilden einer Vielzahl von Anordnungsbereichen (2), die Halbleiterelemente oder -schaltungen enthalten, die darin gebildet sind, und eines Rißbereichs (4) zum Trennen jedes der genannten Anordnungsbereiche voneinander, wobei die genannten Anordnungsbereiche und der Rißbereich auf einem Halbleitersubstrat (1, 6) gebildet werden, welches Verfahren durch die Schritte gekennzeichnet ist:
Bilden einer Vielzahl von ersten Zeichenmustern (B) in dem genannten Rißbereich (4), wobei die ersten Zeichenmuster (B) aus einer Schicht gebildet werden, die auch die genannten Anordnungsbereiche bedeckt und da hervorstehende Kanten bildet;
Bilden einer nachfolgenden Schicht (8) über dem Substrat (6), die die genannten Anordnungsbereiche (2) und den Rißbereich (4) mit den genannten Zeichenmustern (B) bedeckt, welche nachfolgende Schicht (8) eine Bildungsschicht zum Fertigstellen der genannten Anordnungsbereiche ist; und
Ätzen der genannten nachfolgenden Schicht (8) auf solch eine Weise, um eine Vielzahl von zweiten Zeichenmustern (C) zu bilden, und Belassen der genannten ersten Zeichenmuster (B) mit Rückständen (11) an deren Kante;
Bilden einer weiteren Schicht (12) über dem Substrat (1, 6), die die genannten Anordnungsbereiche (2) und den Rißbereich (4) mit den genannten ersten und zweiten Zeichenmustern (B, C) bedeckt, welche weitere Schicht (12) eine Bildungsschicht zum Fertigstellen der genannten Anordnungsbereiche ist; und
Ätzen der genannten weiteren Schicht (12) auf solch eine Weise, um Kantenabdeckungen (17') auf allen Kanten der Zeichenmuster (B, C), die von der Oberfläche des Substrats (1) hervorstehen, und auf all jenen hervorstehenden Kanten der genannten Anordnungsbereiche zu bilden, an denen sich während des Ätzens der genannten weiteren Schicht (12) wahrscheinlich Rückstände bilden, welche Kantenabdeckungen (17') das Substrat (1) kontaktieren, indem sie sich von den Kanten um einen Rand (M) nach außen erstrecken, um ein festes Haften zwischen jeder Kantenabdeckung (17') und dem Substrat (1) zu gewährleisten.

3. Ein Verfahren nach Anspruch 1 oder 2, bei dem die genannten Schritte auf solch eine Weise wiederholt werden, daß jede Kantenabdeckung mit nachfolgenden Kantenabdeckungen bedeckt wird, die bei späteren Schritten zum Abdecken anderer Musterkanten gebildet werden.

4. Ein Verfahren zum Herstellen von Halbleiteranordnungen nach Anspruch 1 oder 2, bei dem der genannte Rand (M) der Erweiterung der genannten Kantenabdeckungen (16, 17, 17') etwa ein bis zehn µm beträgt.

5. Ein Verfahren zum Herstellen von Halbleiteranordnungen nach Anspruch 1 oder 2, bei dem die genannten Kantenabdeckungen (16, 17, 17') durch ein anisotropes Ätzverfahren gemustert werden.

6. Eine Halbleiteranordnung mit Anordnungsbereichen (2), in denen Halbleiterelemente oder -schaltungen gebildet sind, und Rißbereichen (4), die die Anordnungsbereiche teilen, bei der die Anordnungsbereiche und die Rißbereiche auf einem Halbleitersubstrat (1, 6) gebildet sind, bei der weitere Muster mit Kanten, die von der Oberfläche des Substrats hervorstehen, in den Anordnungsbereichen vorkommen und Zeichenmuster (B, C), die von der Substratoberfläche hervorstehen, in dem Rißbereich gebildet sind, welche Zeichenmuster (B) Rückstände (11) von weggeätzten Schichten, die an ihre Kanten grenzen, haben können, und bei der alle hervorstehenden Kanten, die in den Anordnungsbereichen vorkommen, und alle Kanten der Zeichenmuster mit einer Kantenabdeckung (16, 17, 17') bedeckt sind, welche Kantenabdeckungen (16, 17, 17') das Substrat (1) kontaktieren, indem sie sich von den Kanten um einen Rand (M) nach außen erstrecken.

7. Eine Halbleiteranordnung nach Anspruch 6, bei der der genannte Rand (M) der Erweiterung der genannten Kantenabdeckungen in dem Bereich von ein bis zehn µm liegt.

## Revendications

1. Procédé de fabrication de dispositifs à semi-conducteur, comprenant une opération de formation de plusieurs régions (2) de dispositif qui comportent des circuits ou éléments à semi-conducteur formés à l'intérieur et une région d'entaille (4) destinée à la séparation de chacune des régions de dispositif des autres, les régions de dispositif et la région d'entaille étant formées sur un substrat semi-conducteur (1, 6), le procédé comprenant les étapes suivantes :
la formation de plusieurs motifs de repères (B ou C) dans la région d'entaille (4), les motifs de repères étant formés à partir d'une couche qui recouvre aussi les régions de dispositif et formant des bords en saillie,
la formation d'une couche supplémentaire (8 ou 12) sur le substrat (6) afin qu'elle recouvre les régions (2) de dispositif et la région d'entaille (4) comprenant les motifs de repères (B ou C), la couche suivante (8 ou 12) étant une couche de constitution destinée à compléter les régions de dispositif, et
l'attaque de la couche suivante (8 ou 12) de manière qu'elle forme des organes de recouvrement de bords (16 ou 17) sur tous les bords des motifs de repères (B ou C) qui dépassent de la surface du substrat (6 ou 1) et sur tous les bords en saillie des régions de dispositif dans lesquelles des résidus risquent de se former pendant l'attaque de la couche suivante (8 ou 12), et l'organe de recouvrement de bord (16 ou 17) étant au contact du substrat (6 ou 1) par dépassement vers l'extérieur des bords sous forme d'une marge (M) afin qu'une adhérence intime soit assurée entre chaque organe de recouvrement de bord (16 ou 17) et le substrat (6 ou 1).

2. Procédé de fabrication de dispositifs à semi-conducteur, comprenant une opération de formation de plusieurs régions (2) de dispositif qui comprennent des circuits ou éléments à semi-conducteur formés à l'intérieur et une région d'entaille (4) destinée à séparer chacune des régions de dispositif des autres, les régions de dispositif et la région d'entaille étant formées sur un substrat semi-conducteur (1, 6), le procédé étant caractérisé par les étapes suivantes :
la formation de plusieurs premiers motifs de repères (B) dans la région d'entaille (4), les premiers motifs de repères (B) étant formés à partir d'une couche qui recouvre aussi les régions de dispositif et formant les bords en saillie,
la formation d'une couche suivante (8) sur le substrat (6) afin qu'elle recouvre les régions de dispositif (2) et la région d'entaille (4) contenant les motifs de repères (B), la couche suivante (8) étant une couche constituante destinée à compléter les régions de dispositif, et
l'attaque de la couche suivante (8) de manière qu'elle forme plusieurs seconds motifs de repères (C) et laisse les premiers motifs de repères (B) avec des résidus (11) à leurs bords,
la formation d'une couche supplémentaire (12) sur le substrat (1, 6) afin qu'elle recouvre les régions de dispositif (2) et la région d'entaille (4) comprenant les premiers et seconds motifs de repères (B, C), la couche supplémentaire (12) étant une couche de constitution destinée à compléter les régions de dispositif, et
l'attaque de la couche supplémentaire (12) de manière qu'elle forme des organes (17') de recouvrement de bords sur tous les bords des motifs de repères (B, C) qui dépassent de la surface du substrat (1) et sur tous les bords en saillie des régions de dispositif dans lesquelles des résidus risquent de se former pendant l'attaque de la couche supplémentaire (12), les organes de recouvrement de bords (17') étant au contact du substrat (1) par disposition vers l'extérieur des bords sur une marge (M) telle qu'une adhérence intime est assurée entre chaque organe (17') de recouvrement de bord et le substrat (1).

3. Procédé selon la revendication 1 ou 2, dans lequel, ces étapes sont répétées de manière que chaque organe de recouvrement de bord soit recouvert par des organes successifs de recouvrement de bords qui sont formés dans des étapes ultérieures afin qu'ils recouvrent d'autres bords de motifs.

4. Procédé de fabrication de dispositifs à semi-conducteur selon la revendication 1 ou 2, dans lequel ladite marge (M) dont dépassent les organes de recouvrement de bords (16, 17, 17') a une dimension comprise entre environ 1 et 10 µm.

5. Procédé de fabrication de dispositifs à semi-conducteur selon la revendication 1 ou 2, dans lequel les organes de recouvrement de bords (16, 17, 17') sont mis sous forme de motifs par une opération d'attaque anisotrope.

6. Dispositif à semi-conducteur ayant des régions (2) de dispositif dans lesquelles des circuits ou éléments semi-conducteurs sont formés, et des régions d'entaille (4) séparant les régions de dispositif, dans lequel les régions de dispositif et les régions d'entaille sont formées sur un substrat semi-conducteur (1, 6), dans lequel d'autres motifs ayant des bords en saillie par rapport à la surface du substrat sont formés dans les régions de dispositif et des motifs de repères (B, C) dépassant de la surface du substrat sont formés dans la région d'entaille, ces motifs de repères (B) pouvant avoir des résidus (11) de couche attaquée près de leurs bords, et dans lequel tous les bords en saillie apparaissant dans les régions de dispositif et tous les bords des motifs de repères sont recouverts par un organe de recouvrement de bord (16, 17, 17'), les organes (16, 17, 17') de recouvrement de bords étant au contact du substrat (1, 6) par disposition vers l'extérieur des bords sur une marge (M).

7. Dispositif à semi-conducteur selon la revendication 6, dans lequel la marge (M) dont dépassent les organes de recouvrement de bords a une dimension comprise entre 1 et 10 µm.
